Europäisches Patentamt

European Patent Office

Office européen des brevets

(11) Numéro de publication: **0 420 337 A1**

# DEMANDE DE BREVET EUROPEEN

(21) Numéro de dépôt: 90202518.8

(22) Date de dépôt: 24.09.90

(51) Int. Cl.5: **H01P 5/10, H03D 9/06**

(30) Priorité: 26.09.89 FR 8912585

(43) Date de publication de la demande:
03.04.91 Bulletin 91/14

(84) Etats contractants désignés:
DE FR GB IT

(71) Demandeur: TRT TELECOMMUNICATIONS
RADIOELECTRIQUES ET TELEPHONIQUES
88 rue Brillat Savarin
F-75013 Paris(FR)
(84) FR

Demandeur: N.V. Philips'
Gloeilampenfabrieken
Groenewoudseweg 1
NL-5621 BA Eindhoven(NL)
(84) DE GB IT

(72) Inventeur: Podvin, Dominique
Société Civile S.P.I.D., 156 Boulevard
Haussmann
F-75008 Paris(FR)

(74) Mandataire: Chaffraix, Jean et al
Société Civile S.P.I.D. 156, Boulevard
Haussmann
F-75008 Paris(FR)

(54) Mélangeur hyperfréquence équilibré à circuit "balun".

(57) Ce mélangeur hyperfréquence équilibré est élaboré autour d'un circuit du type "balun". Bien que
réalisé pour fonctionner dans une gamme de fréquence d'environ 1 GHz à 10 GHz, le substrat
diélectrique SUB utilisé est choisi parmi les matériaux diélectriques à fortes pertes tels que le verre-
époxy permettant ainsi de minorer très sensiblement
son prix de revient. Sur ledit substrat est imprimé un
circuit d'adaptation par lignes microstrip $L_1$, $L_2$ partiellement recouvertes, $L_1$ par un tronçon de câble
coaxial CC semi-rigide, $L_2$ par un tronçon de fil
conducteur CA de même diamètre et de même
longueur que le câble coaxial. Les performances
d'un tel mélangeur sont comparables à celles d'un
mélangeur $6\lambda/4$ avec un encombrement nettement
plus faible, de l'ordre de celui d'un coupleur de
Lange.
Application : circuits hyperfréquences radioaltimètres

FIG.3

## MÉLANGEUR HYPERFRÉQUENCE ÉQUILIBRÉ À CIRCUIT "BALUN".

La présente invention concerne un mélangeur hyperfréquence équilibré élaboré autour d'un circuit du type "balun" principalement constitué d'un substrat diélectrique supportant des configurations en matériau conducteur telles que lignes et plan de masse situés dans des plans parallèles ou confondus.

De manière générale, les mélangeurs équilibrés en hyperfréquence utilisant des circuits du type microstrip sont constitués d'un coupleur à fort couplage (3 dB) associé à des diodes combinant l'élément non linéaire du mélangeur. Un tel coupleur est présenté dans la demande de brevet européenne publiée sous le numéro 0 213 864 qui décrit un circuit du type "balun" c'est-à-dire un circuit permettant le couplage d'une ligne équilibrée avec une ligne non équilibrée. Dans ladite demande de brevet le circuit "balun" est ainsi principalement constitué d'un substrat diélectrique sur la surface duquel sont disposées des lignes en matériau conducteur. Il est bien connu que lorsque le substrat présente des pertes diélectriques importantes le fonctionnement du mélangeur se dégrade. Ainsi la solution classique consiste à rapporter un mélangeur construit sur un substrat à faibles pertes appelé également substrat noble, tel que le verre-téflon, le duroïd ou comme cela est préconisé dans la demande de brevet précitée, une céramique ou un matériau semiconducteur. Le principal inconvénient que présente le choix de ce type de substrat est relatif au coût de fabrication du mélangeur.

La présente invention a pour but de remédier à cet inconvénient et propose un mélangeur dont le coût de fabrication et donc le prix de revient est très sensiblement réduit bien qu'offrant de très bonnes performances.

Pour cela le mélangeur hyperfréquence mentionné dans le préambule est remarquable en ce que, d'une part le substrat est choisi parmi les matériaux diélectriques à fortes pertes, d'autre part un tronçon de câble coaxial semi-rigide à faible perte est associé à une ligne en matériau conducteur tandis qu'un tronçon de fil conducteur de même longueur et de même diamètre que le câble, relié au câble est associé à une seconde ligne en matériau conducteur lesdits tronçons de câble coaxial et de fil recouvrant au moins partiellement lesdites lignes en matériau conducteur.

Ainsi l'idée de l'invention consiste à utiliser contre toute attente dans le domaine des hyperfréquences, un substrat à fortes pertes (non spécifique aux utilisations hyperfréquences) de même que des tronçons de câble coaxial et de fil conducteur soudés sur les lignes d'équilibrage et ceci pour des applications dont la fréquence d'utilisation peut être de l'ordre de 10 GHz. A des fréquences aussi élevées l'homme de l'art proscrira immanquablement le choix d'un tel substrat ou l'utilisation d'un câble coaxial. Or l'expérience montre que le mélangeur selon l'invention fonctionne et offre des performances en tous points équivalentes à celles d'un mélangeur du type $6\lambda/4$, tout en présentant un encombrement de l'ordre de celui du coupleur de Lange et ceci pour un coût très sensiblement réduit. En effet, le circuit "balun" constitué, entre autres, d'un câble semi-rigide à faible perte est soudé par sa gaine sur une ligne d'équilibrage, les éléments du mélangeur présentant des pertes sont ainsi réduits au minimum : plots de soudure des diodes et lignes d'équilibrage.

Selon une application préférée il est employé un circuit imprimé double face en verre-époxy, le substrat diélectrique à fortes pertes étant constitué par le verre-époxy, les lignes et plan de masse conducteurs étant obtenus par gravage du circuit imprimé, alors que les tronçons de câble coaxial semi-rigide et de fil conducteur sont soudés sur les lignes conductrices. En effet le verre-époxy est un matériau bon marché et robuste, sa robustesse autorisant à un allégement de la structure du mélangeur, la mécanique environnante n'étant plus nécessaire.

Enfin selon une variante, il peut être avantageusement utilisé un circuit imprimé multicouche en verre-époxy, une telle configuration permettant de réaliser une pluralité de fonctions.

La description suivante en regard des dessins annexés, le tout donné à titre d'exemple non limitatif, fera bien comprendre comment l'invention peut être réalisée.

La figure 1 propose un exemple de circuit imprimé pour le mélangeur conforme à l'invention.

La figure 2 montre un exemple d'agencement des principaux composants nécessaires au fonctionnement du mélangeur.

La figure 3 montre le cheminement des signaux dans le circuit vu du côté signal provenant de l'oscillateur local.

La figure 4 montre le cheminement des signaux dans le circuit vu du côté signal RF.

La figure 5 propose un schéma équivalent du mélangeur.

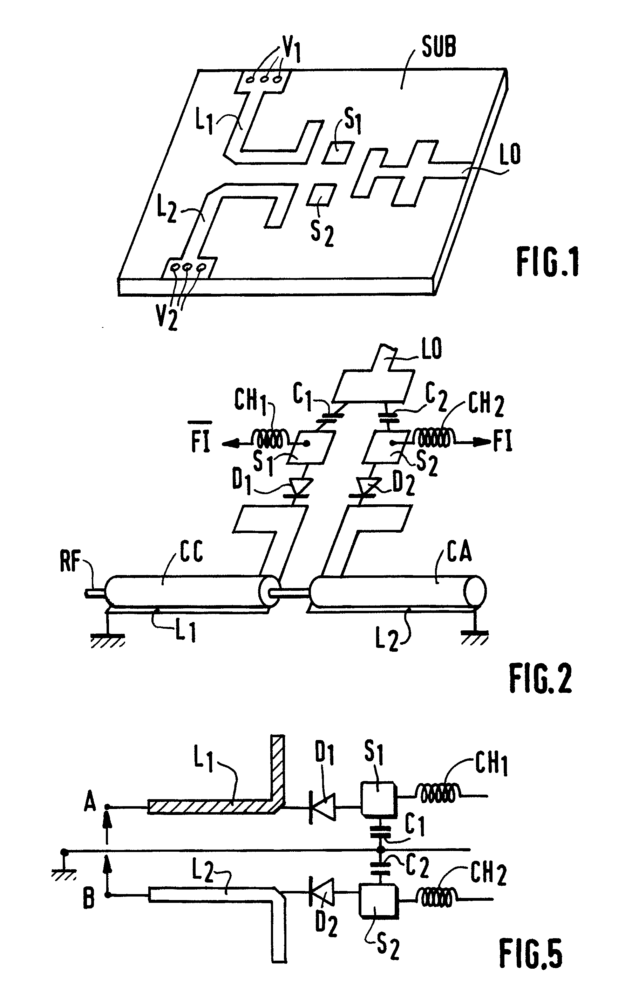

La figure 1 propose un exemple de circuit imprimé double face cuivre à substrat à fortes pertes (SUB) par exemple en verre-époxy pouvant être utilisé dans le mélangeur conforme à l'invention. Sur la figure n'apparaît pas le plan de masse qui est porté par la contreface ; le plan de masse est réalisé en plein cuivre. Sur la face supérieure (visible sur la figure) sont imprimées deux lignes

(microstrip) $L_1$ et $L_2$ qui sont symétriques, ont une même longueur et sont mises à la masse (plan de masse) par l'intermédiaire de trous métallisés : $V_1$ et $V_2$. Sont également imprimés deux plots $S_1$ et $S_2$ identiques et symétriques ainsi que la ligne LO recevant le signal provenant de l'oscillateur local.

La figure 2 permet de montrer l'étape suivante de la réalisation du mélangeur selon l'invention qui consiste à souder un tronçon de câble CC semi-rigide sur la ligne microstrip Li, le câble coaxial recouvrant partiellement la ligne L1. La ligne microstrip fixe l' impédance caractéristique $Z_c$ de la gaine du câble coaxial par rapport à la masse. L'entrée RF (câble coaxial CC) reçoit le signal RF qui doit être mélangé avec le signal LO provenant de l'oscillateur local. Sur la ligne $L_2$ qui est le circuit d'adaptation est soudé un tronçon de fil conducteur CA de même longueur et de même diamètre que le câble coaxial CC, la ligne $L_2$ étant donc recouverte partiellement par le fil conducteur CA sur une longueur identique à celle de la partie de ligne $L_1$ recouverte par le câble coaxial CC. Le câble coaxial CC et le fil conducteur CA sont reliés. Enfin, comme cela est montré sur la figure 2, les diodes $D_1$ et $D_2$, les condensateurs $C_1$ et $C_2$ ainsi que les selfs de choc $CH_1$ et $CH_2$ sont soudés sur le circuit imprimé. Les cathodes des diodes $D_1$ et $D_2$ sont respectivement connectées aux lignes $L_1$ et $L_2$, tandis que les anodes des diodes $D_1$ et $D_2$ sont respectivement connectées aux plots $S_1$ et $S_2$. Les condensateurs $C_1$ et $C_2$ sont connectés par leurs premières extrémités à la ligne LO recevant le signal provenant de l'oscillateur local alors que les secondes extrémités des condensateurs $C_1$ et $C_2$ sont respectivement connectées aux plots $S_1$ et $S_2$. Enfin les selfs de choc $CH_1$ et $CH_1$ sont connectées par leurs premières extrémités respectivement aux plots 57 et 51 permettant ainsi le prélèvement sur leurs secondes extrémités des signaux $\overline{FI}$ et FI, signaux à fréquence intermédiaire en opposition de phase.

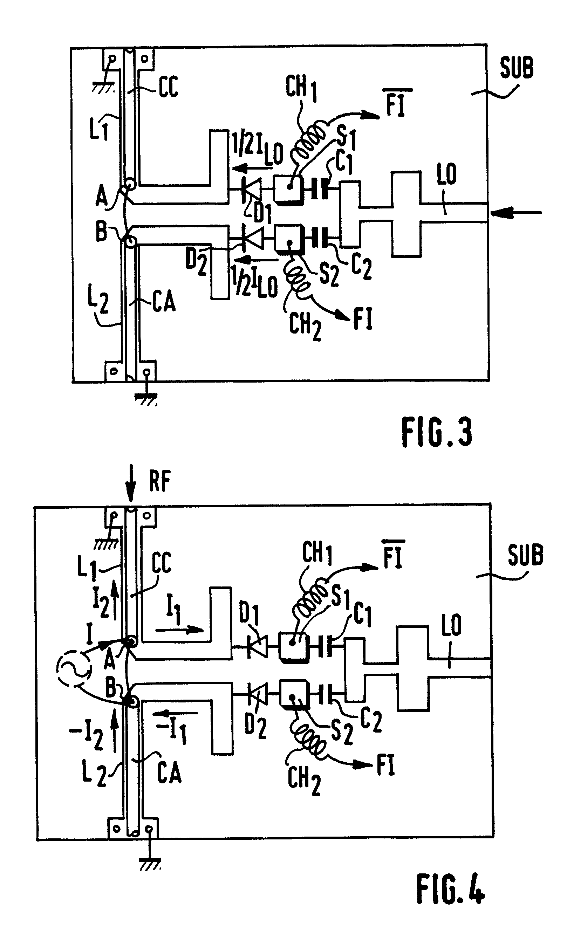

Les figures 3 et 4 permettent de comprendre le fonctionnement du circuit en suivant le cheminement des signaux dans ledit circuit respectivement vu du côté signal LO provenant de l'oscillateur local, puis vu du côté signal RF.

Considérons tout d'abord le circuit vu du côté du signal LO (figure 3). Par symétrie le signal LO provenant de l'oscillateur local se répartit également entre les deux circuits formés d'une part par les éléments $C_1$, $D_1$ et $L_1$ et d'autre part par les éléments $C_2$, $D_2$ et $L_2$. Ainsi la moitié du courant $I_{LO}$ en provenance de l'oscillateur local est dérivée vers le circuit formé par $C_1$, $D_1$, $L_1$ alors que la seconde moitié est dérivée vers le circuit formé par $C_2$, $D_2$, $L_2$. Soient les points A et B, A étant l'extrémité du câble coaxial CC reliée à l'extrémité B du fil conducteur CA. Comme les deux points A et B sont équipotentiels, aucune puissance n'est envoyée à l'intérieur du câble CC vers le côté du signal RF.

Inversement lorsque le circuit est vu du côté signal RF (figure 4), le câble coaxial peut être considéré comme un générateur RF (symbolisé par le générateur de signaux alternatifs en pointillé sur la figure) qui serait connecté entre les points A et B. Le courant 1 au point A se divise en $I_1$, courant dérivé dans la diode $D_1$ et $I_2$ courant dérivé dans la branche de $L_1$ recouverte par le câble coaxial CC. Par symétrie, au point B est récupéré le courant $-I$ formé par la somme du courant $-I_1$ venant de la diode $D_2$ et du courant $-I_2$ venant de la branche de ligne $L_2$ recouverte par le fil conducteur CA. La ligne LO n'est alors le siège d'aucune tension et donc aucune puissance n'est envoyée vers l'oscillateur local ce qui signifie que les circuits LO et RF sont bien découplés.

Considérons à présent le mélangeur en fonctionnement c'est-à-dire lorsqu'il se voit appliquer simultanément le signal RF et le signal LO. Les deux diodes $D_1$ et $D_2$ sont attaquées en parallèle et donc en phase par le signal LO, à l'inverse elles sont attaquées en série et donc en opposition de phase par le signal RF. Ainsi après mélange sera obtenu un signal FI en opposition de phase (avec $\overline{FI}$ ) sur l'une et l'autre diode.

Le signal de fréquence intermédiaire est prélevé au moyen d'une self de choc ($CH_1$ pour $\overline{FI}$ et $CH_2$ pour FI) d'impédance très élevée en haute fréquence c'est-à-dire pour les fréquences des signaux RF et LO et d'impédance très faible à la fréquence intermédiaire FI.

Outre la manière de réaliser le mélangeur selon l'invention, une analyse simple mais explicite permettra de mieux appréhender d'une part l'idée de l'invention et de mieux comprendre d'autre part les résultats obtenus, résultats surprenants pour l'homme de l'art. Cette analyse peut être dissociée en deux parties relatives à deux questions.

La première question peut être formulée ainsi. Pourquoi l'utilisation d'un substrat à pertes est-elle possible dans un mélangeur à circuit "balun" ?

Les pertes dans un circuit hyperfréquence peuvent se décomposer en pertes par conduction, c'est-à-dire pertes série dans le cuivre, et en pertes diélectriques, c'est-à-dire pertes parallèles.

Un circuit dont le diélectrique présente des pertes voit donc augmenter les pertes parallèles. Ces pertes sont fonction de l'impédance des circuits, plus l'impédance est élevée et plus les pertes sont importantes.

Les mélangeurs hyperfréquences habituels sont symétriques et il est bien souvent possible d'inverser l'entrée RF (signal) et l'entrée LO (oscillation locale) sans dégrader sensiblement le fonctionnement.

Mais le mélangeur à circuit "balun" est nettement dissymétrique (par définition). Ainsi le circuit LO se trouve exclusivement sur le substrat présentant des pertes ; il est cependant facile de compenser ces dernières en augmentant le niveau à l'entrée LO.

Du côté circuit RF (voir figure 4), le signal RF arrive sans perte par le câble aux points A et B, où il est divisé en deux parties symétriques ayant chacune 25 Ω d'impédance puisque le câble d'impédance 50 Ω doit débiter dans les parties en série.

Sur la figure 5 (schéma équivalent du mélangeur), la capacité $C_1$ se comporte comme un court-circuit HF, les pertes du circuit RF élémentaire sont limitées au tronçon hachuré, qui permet l'adaptation d'impédance de 50 Ω à 25 Ω de la diode $D_1$.

Les pertes sont réduites du fait de la faible dimension du circuit d'une parc et de la faible impédance d'autre part.

Ainsi la dissymétrie du mélangeur à circuit "balun" est intéressante car elle permet de minimiser les pertes diélectriques du circuit RF, ce qui explique les bonnes performances de ce mélangeur utilisant comme substrat du verre-époxy.

La seconde question peut être également formulée ainsi. Pourquoi un câble coaxial peut-il être utilisé à des fréquences de l'ordre de 10 GHz ?

De manière habituelle, l'homme du métier, en hyperfréquence, considère comme une règle qu'un élément de ligne de transmission inférieur à λ/10 ( λ étant la longueur d'onde) peut être négligé.

Dans le principe, un câble coaxial semi-rigide est une ligne de transmission apériodique ; les éléments limitant son utilisation vers les hautes fréquences sont les deux branchements du câble, qui dans le cas du mélangeur à circuit "balun" sont des fils (dont l'un est l'âme de câble coaxial) soudés dont la longueur est voisine du diamètre extérieur d du câble coaxial. La règle précédente permet alors d'énoncer la relation : d<λ câble/10.

Si par exemple d = 1,3 mm, il s'ensuit que la longueur d'onde λ câble doit être supérieure à 13 mm, avec $\epsilon_r$ = 2 il est autorisé une fréquence maximum d'environ 15 GHz. En limitant la fréquence d'utilisation du mélangeur selon l'invention à 10 GHz, une marge de sécurité importante est assurée et un bon fonctionnement est ainsi garanti.

Un tel mélangeur peut être avantageusement utilisé dans un bloc émetteur-récepteur pour radioaltimètre.

Selon un exemple de réalisation, pour une bande de fréquence d'utilisation située de 4,2 à 4,4 GHz et pour un choix du diamètre extérieur du câble coaxial semi-rigide de 1,2 mm, la longueur du câble coaxial était de 11 mm. Ce câble coaxial était soudé sur une ligne d'équilibrage de 1,6 mm de largeur et de 11 mm de longueur supportée par un substrat en verre-époxy de 0,8 mm d'épaisseur.

Dans cette réalisation, l'isolation LO/RF obtenue était de 26 dB dans la bande précitée et le facteur de bruit NF du récepteur mesuré à la fréquence FI du radioaltimètre (25 kHz) était de 10 dB ce qui est tout à fait comparable à celui de mélangeurs équivalents fonctionnant dans les mêmes conditions mais réalisés sur des substrats nobles tels que du verre-téflon.

Un tel mélangeur peut avantageusement remplacer un mélangeur en anneau 6λ/4 dès qu'il y a un problème de place ou un problème de qualité de substrat du circuit imprimé.

Ce type de mélangeur est apériodique, rien dans le principe ne le fait dépendre de la fréquence, c'est l'adaptation des circuits qui limite la réponse en fréquence. Ainsi, bien qu'il soit théoriquement apériodique, la limitation provient des circuits d'adaptation LO et RF. En effet, et en première approximation, si Zd est l'impédance d'une diode mélangeuse ($D_1$ ou $D_2$), le circuit LO doit adapter deux fois l'impédance Zd en parallèle soit Zd/2 et le circuit RF deux fois l'impédance Zd en série soit 2Zd, ce qui a pour effet de limiter la bande de fréquence.

Une autre limitation peut provenir de la réalisation pratique des tronçons de câble. Ainsi, vers les fréquences basses, la longueur des lignes d'équilibrage limite le domaine d'application aux environs de 1 GHz. A cette fréquence la longueur du tronçon est égale à 40 mm. De même vers les fréquences hautes, la réalisation du tronçon de câble de longueur calibrée deviendra délicate. La longueur du tronçon de câble étant égale à 3 mm à une fréquence de 10 GHz, il semble que ce seuil soit difficilement excédé.

En conclusion, un tel mélangeur peut être avantageusement utilisé dans une bande de fréquence de 1 GHz à 10 GHz car il est robuste, d'un encombrement réduit et de par son faible coût permet de réduire sensiblement le prix de revient d'un matériel qui utiliserait plusieurs éléments mélangeurs comme c'est couramment le cas. En outre lors de différents essais comparatifs, ce mélangeur comparé dans les mêmes conditions de fonctionnement à un mélangeur classique en anneau 4λ/4 (mélangeur à deux branches) doté d'un substrat noble, tel que le verre-téflon, a donné de meilleurs résultats. Ainsi ces essais comparatifs ont permis de constater un découplage entre le signal RF et le signal LO supérieur d'environ 10 dB (une amélioration de pratiquement 1/3) en faveur du mélangeur selon la présente invention.

**Revendications**

1. Mélangeur hyperfréquence équilibré élaboré au-

4

tour d'un circuit du type "balun" principalement constitué d'un substrat diélectrique supportant des configurations en matériau conducteur telles que lignes et plan de masse situés dans des plans parallèles ou confondus, caractérisé en ce que d'une part le substrat est choisi parmi les matériaux diélectriques à fortes pertes, d'autre part un tronçon de câble coaxial semi-rigide à faible perte est associé à une ligne en matériau conducteur tandis qu'un tronçon de fil conducteur de même longueur et de même diamètre que le câble, relié au câble est associé à une seconde ligne en matériau conducteur lesdits tronçons de câble coaxial et de fil recouvrant au moins partiellement lesdites lignes en matériau conducteur.

2. Mélangeur hyperfréquence équilibré selon la revendication 1, caractérisé par l'emploi d'un circuit imprimé double face en verre-époxy, le substrat diélectrique à fortes pertes étant constitué par le verre-époxy, les lignes et plan de masse conducteur étant obtenus par gravage du circuit imprimé, alors que les tronçons du câble coaxial semi-rigide et de fil conducteur sont soudés sur les lignes conductrices.

3. Mélangeur hyperfréquence équilibré selon la revendication 1, caractérisé par l'emploi d'un circuit imprimé multicouche en verre-époxy pour l'élaboration d'une pluralité de fonctions.

FIG.1

FIG.2

FIG.5

6

FIG.3

FIG.4

Office européen
des brevets

RAPPORT DE RECHERCHE
EUROPEENNE

Numéro de la demande

EP 90 20 2518

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 063 819 (SIEMENS AG) <br> * Page 4, ligne 1 - page 5, ligne 14; page 9, lignes 4-33; figures 1,2 * | 1-3 | H 01 P 5/10 <br> H 03 D 9/06 |
| Y | NACHRICHTENTECHNIK-ELEKTRONIK, vol. 26, no. 2, février 1976, pages 74-76; I. LANGER: "Leitungen zur Stromversorgung für schnelle integrierte Schaltkreise auf Mehrlagenleiterplatten" <br> * Page 74, colonne de gauche, lignes 24-27; colonne de droite, lignes 18-22; figure 2 * | 1-3 | |
| A | US-A-3 786 372 (EPIS et al.) <br> * Colonne 2, lignes 13-66; figures 2,3 * | 1 | |
| A | PATENT ABSTRACTS OF JAPAN, vol. 12; no. 342 (E-658)[3189], 14 septembre 1988; <br> & JP-A-63 102 406 (MATSUSHITA ELECTRIC IND. CO., LTD) 07-05-1988 <br> * En entier * | 1-3 | |

|  |  |  | DOMAINES TECHNIQUES RECHERCHES (Int. Cl.5) |
|---|---|---|---|
|  |  |  | H 01 P <br> H 03 D |

Le présent rapport de recherche a été établi pour toutes les revendications

| Lieu de la recherche | Date d'achèvement de la recherche | Examinateur |
|---|---|---|
| La Haye | 14 décembre 90 | DEN OTTER A.M. |